# EUROPÄISCHE PATENTANMELDUNG

(11) **EP 1 429 589 A2**
(43) Veröffentlichungstag der Anmeldung: **16.06.2004**
(21) Anmeldenummer: 03028364.2
(22) Anmeldetag: 10.12.2003
(51) Int. Cl.: H05K 3/32, H05K 1/11, H01R 12/38

(54) **Schaltungsträger**

(30) Priorität: 10.12.2002 DE 10257527
(71) Anmelder: Marquardt GmbH, 78604 Rietheim-Weilheim (DE)
(72) Erfinder: Neitzel, Roland, 78570 Mülheim (DE); Stegerwald, Gerhard, 97816 Lohr am Main (DE)
(74) Vertreter: Otten, Herbert

(57) **Zusammenfassung**

Die Erfindung betrifft einen Schaltungsträger (3) für eine elektrische Schaltung, insbesondere in der Art einer wenigstens teilweise flexiblen Leiterplatte. Der Schaltungsträger (3) weist elektrische, elektronische o. dgl. Bauteile (2), wie einen Elektromotor (2a), Schalter (2b), Widerstand, Kondensator, Spule, IC, Steckanschluß o. dgl. auf. Weiter besitzt der Schaltungsträger (3) Leiterbahnen zur elektrischen Verbindung der Bauteile (2) sowie Kontaktflächen (5) zur elektrischen Kontaktierung der Bauteile (2). Die Kontaktfläche (5) ist wenigstens teilweise in der Ebene des Schaltungsträgers (3) freigeschnitten, derart daß die Kontaktfläche (5) eine Flexibilität in eine außerhalb der Ebene (6) des Schaltungsträgers (3) verlaufende Richtung aufweist, insbesondere in der Art einer Kontaktzunge. Ein Kontaktelement (8) zur elektrischen Kontaktierung des Bauteils (2) liegt mit einem Anpreßdruck derart an der Kontaktfläche (5) an, daß die Kontaktfläche (5) aus der Ebene (6) des Schaltungsträgers (3) ausgelenkt ist.

## Beschreibung

Die Erfindung betrifft einen Schaltungsträger für eine elektrische Schaltung nach dem Oberbegriff des Patentanspruchs 1 oder 2.

Solche Schaltungsträger werden in Steuergeräten für Kraftfahrzeuge eingesetzt. Beispielsweise kann es sich um ein Steuergerät für den elektrischen Fensterheber, die Spiegelverstellung, die Zentralverriegelung o. dgl. handeln.

Auf dem Schaltungsträger ist eine elektrische Schaltung mit elektrischen, elektronischen o. dgl. Bauteilen, bei denen es sich beispielsweise um Elektromotoren, Schaltern, Widerständen, Kondensatoren, Spulen, ICs, Steckanschlüssen handeln kann, angeordnet. Weiter besitzt der Schaltungsträger zur elektrischen Verbindung der Bauteile dienende Leiterbahnen sowie zur elektrischen Kontaktierung der Bauteile dienende Kontaktflächen. Diese Schaltungsträger können starr oder auch in der Art einer wenigstens teilweise flexiblen Leiterplatte ausgestaltet sein.

Nachteilig bei den bekannten Schaltungsträgern ist, daß zur Kontaktierung der Bauteile mit den Kontaktflächen ein Verlöten oder Verkleben notwendig ist. Dies erfordert teuere und gegebenenfalls ökologisch bedenkliche Zusatzstoffe, beispielsweise Lötzinn oder Leitkleber. Außerdem ist ein zusätzlicher Verbindungsarbeitsgang, wie Schweißen, Aufheizen o. dgl., notwendig, was letztendlich die Montage des Schaltungsträgers verteuert.

Der Erfindung liegt die Aufgabe zugrunde, den Schaltungsträger derart weiterzuentwickeln, daß auf die Verwendung von Zusatzstoffen sowie auf einen zusätzlichen Verbindungsarbeitsgang bei der Kontaktierung der Bauteile verzichtet werden kann. Insbesondere soll der Schaltungsträger unter rauhen Einsatzbedingungen, wie beispielsweise im Kraftfahrzeugbereich, einsetzbar sein.

Diese Aufgabe wird bei einem gattungsgemäßen Schaltungsträger durch die kennzeichnenden Merkmale des Anspruchs 1 oder 2 gelöst. Ein entsprechendes Verfahren zur Herstellung eines derartigen Schaltungsträgers ist in den Ansprüchen 9 oder10 angegeben.

Beim erfindungsgemäßen Schaltungsträger in einer ersten Ausführungsform ist die Kontaktfläche wenigstens teilweise in der Ebene des Schaltungsträgers freigeschnitten, derart daß die Kontaktfläche eine Flexibilität in eine außerhalb der Ebene des Schaltungsträgers verlaufende Richtung aufweist und somit eine Art von Kontaktzunge bildet. Ein Kontaktelement zur elektrischen Kontaktierung des Bauteils liegt mit einem Anpreßdruck derart an der Kontaktfläche an, daß die Kontaktfläche aus der Ebene des Schaltungsträgers ausgelenkt ist.

In einer zweiten Ausführungsform ist die Kontaktfläche wenigstens teilweise in der Ebene des Schaltungsträgers freiliegend angeordnet, womit die Kontaktfläche für ein Kontaktelement zur elektrischen Kontaktierung des Bauteils zugänglich ist. Das Kontaktelement liegt mit einem Anpreßdruck an der Kontaktfläche an, und zwar mit einem in etwa um 90 Grad seitlich abgebogenen Auflagefuß. Besonders bevorzugt ist dabei, daß das Kontaktelement zwei flügelartig gegenläufig abgebogene Auflagefüße zur Anlage an die Kontaktfläche aufweist.

Beide Ausgestaltungen gestatten somit in einfacher Art und Weise eine lotfreie Verbindung des Bauteils mit der Kontaktfläche. Weitere Ausgestaltungen der Erfindung sind Gegenstand der Unteransprüche.

Besonders vorteilhaft ist, wenn es sich bei dem Schaltungsträger um eine flexible Schaltungsträgerfolie handelt, so daß die Kontaktfläche bereits ohne weitere Maßnahmen über die erforderliche Biegefähigkeit verfügt. Die Folie einer solchen Schaltungsträgerfolie kann aus Polyimid, Polyethylennaphtalat o. dgl. bestehen, wobei die Leiterbahnen in herkömmlicher Weise aus Kupfer auf der Folienoberfläche aufgebracht sind. Die Kontaktfläche kann dann in einfacher Weise als freigeschnittenes und/oder freiliegendes Ende einer Leiterbahn ausgestaltet sein. Zweckmäßigerweise ist der Zungengrund an der Folie des freiliegenden Endes abgerundet, um ein Einreißen der Schaltungsträgerfolie bei Montage des Kontaktelements zu verhindern.

Um trotz der Flexibilität der Schaltungsträgerfolie die notwendige Stabilität für die Montage im Steuergerät o. dgl. zu gewährleisten, bietet es sich an, die Schaltungsträgerfolie an einem Trägerelement anzuordnen. Das Trägerelement kann aus Kunststoff bestehen und beispielsweise in Spritzgießtechnik hergestellt sein. Das Trägerelement mitsamt der darauf befestigten Schaltungsträgerfolie bildet dann eine Art von Elektrokomponententräger. Weiter wird dadurch eine definierte Lage der Kontaktflächen ohne zusätzliche Haltevorrichtungen erreicht. Außerdem werden Kräfte auf die Folie beim Anbringen der Kontaktelemente durch das Trägerelement aufgenommen. Schließlich werden auch Rißbildungen in der Schaltungsträgerfolie bei Schwingungen, wie sie beispielsweise beim Einsatz im Kraftfahrzeug auftreten können, wirksam verhindert.

Zur Befestigung der Schaltungsträgerfolie auf dem Trägerelement bietet sich Kleben, Nieten, Prägen o. dgl. an, wobei beim Kleben eine anschließende Wärmeaushärtung des Klebers erfolgen kann. Auch ein Hinterspritzen der Schaltungsträgerfolie mit dem Trägerelement ist möglich. Soweit eine eventuell wieder lösbare Befestigung gewünscht ist, kann die Schaltungsträgerfolie mittels Schnappverbindungen am Trägerelement festgelegt sein. Schließlich kann die Schaltungsträgerfolie auf wenigstens einen Fixierzapfen am Trägerelement aufgesteckt sein. Der Fixierzapfen läßt sich dann zur Befestigung der Schaltungsträgerfolie anschließend noch thermisch verformen.

Eine einfache Montage des Kontaktelements, die sich dennoch durch eine besondere Kontaktsicherheit des Kontaktelements auszeichnet, ist dadurch gegeben, daß im Trägerelement eine Aufnahme, eine Ausnehmung, eine Ausformung o. dgl. angebracht ist. Die Kontaktfläche ragt in diese Aufnahme hinein, und das Kontaktelement ist kraft - und/oder formschlüssig in die Aufnahme eingesteckt. Dadurch liegt das Kontaktelement an der Kontaktfläche mit dem nötigen Anpreßdruck an. Zur Erhöhung der Haltekraft des Kontaktelements in der Aufnahme kann eine Verzahnung am Kontaktelement verwendet werden, so daß sich das in die Aufnahme eingesteckte Kontaktelement im Material der Aufnahme eingräbt.

Das Kontaktelement läßt sich in der Art eines Steckverbinders ausbilden. Hierzu besitzt das Kontaktelement einen wenigstens teilweise freigeschnittenen Abschnitt. Nachdem das Kontaktelement in die Aufnahme eingesteckt ist, befindet sich dieser freigeschnittene Abschnitt dann in der Aufnahme und liegt zur Kontaktgabe mit einer Andrückkraft an der Kontaktfläche an. Der freigeschnittene Abschnitt läßt sich in fertigungstechnisch einfacher Art als eine federartige Zunge, einen federnden Schenkel o. dgl. ausgestalten. Beispielsweise kann eine solche federnde Zunge durch einen U-förmigen Einschnitt mit anschließender Ausklinkung der Zunge in ein entsprechendes Flachmaterial hergestellt werden. Bei dem Flachmaterial für das Kontaktelement kann es sich um Bronzeblech handeln, dessen Oberfläche bei Bedarf noch verzinnt sein kann. Falls gewünscht, kann zur Ausübung und/oder Erhöhung der Anpreßkraft des freigeschnittenen Abschnittes an die Kontaktfläche in der Aufnahme eine keilförmige Erhöhung, ein federnder Steg o. dgl. angeordnet sein.

Das Kontaktelement kann bereits am Bauteil bei dessen Herstellung befestigt werden. Handelt es sich bei dem Bauteil um einen elektrischen Schalter, so bietet es sich in diesem Fall an, dessen Anschlüsse in der Form von Kontaktelementen auszugestalten. Alternativ kann es sich beim Kontaktelement auch um ein bezüglich des Bauteils separates Teil handeln. Beispielsweise läßt sich ein handelsüblicher Elektromotor mittels eines solchen separaten Kontaktelements mit der Kontaktfläche in einfacher Weise elektrisch verbinden. Das Kontaktelement kann seinerseits eine Schneidklemm-Kontaktierung zum Bauteil aufweisen, um die elektrische Verbindung zum Bauteil in einfacher Art und Weise herzustellen.

Zur Herstellung eines erfindungsgemäßen Schaltungsträgers ist zum einen nachfolgendes Herstellverfahren besonders bevorzugt. Die Schaltungsträgerfolie wird derart auf dem Trägerelement plaziert, daß die Kontaktflächen im Bereich der Aufnahme befindlich sind. Anschließend wird das Kontaktelement in die Aufnahme eingeführt, so daß das Kontaktelement bei der Montage die Kontaktfläche in die Aufnahme mit hineinzieht. Dadurch liegt dann nach der Montage das Kontaktelement mit einem Anpreßdruck an der in der Aufnahme befindlichen Kontaktfläche an.

Zum anderen läßt sich der erfindungsgemäße Schaltungsträger auch wie folgt herstellen. Bereits bei der Plazierung der Schaltungsträgerfolie auf dem Trägerelement wird die flexible Kontaktfläche in die Aufnahme gelegt. Falls notwendig kann die Kontaktfläche dabei in der Aufnahme befestigt werden. Anschließend wird dann wiederum das Kontaktelement in die Aufnahme eingeführt. Dabei liegt nach der Montage das Kontaktelement mit einem Anpreßdruck an der in der Aufnahme befindlichen Kontaktfläche an.

Die beiden Herstellverfahren für den erfindungsgemäßen Schaltungsträger zeichnen sich durch Einfachheit und Kostengünstigkeit aus.

Die mit der Erfindung erzielten Vorteile bestehen insbesondere darin, daß für den Schaltungsträger eine Kontaktierung ohne Verwendung von Zusatzstoffen, wie Lötzinn, Leitkleber o. dgl., erreicht wird. Außerdem entfällt ein zusätzlicher Verbindungsarbeitsgang, beispielsweise Schweißen oder Aufheizen. Das gewährleistet zum einen eine verbesserte Umweltverträglichkeit sowie zum anderen die Einsparung von Kosten. Darüber hinaus wird eine gute Funktionssicherheit auch in rauhen Umgebungsbedingungen, beispielsweise beim Einsatz in Kraftfahrzeugen, erzielt.

Ausführungsbeispiele der Erfindung sind in den Zeichnungen dargestellt und werden im folgenden näher beschrieben. Es zeigen
- Fig. 1: einen Elektrokomponententräger in Seitenansicht,
- Fig. 2: eine Draufsicht auf die Schaltungsträgerfolie,
- Fig. 3: eine Detailansicht des Elektrokomponententrägers, wobei der Kontaktanschluß noch nicht montiert ist,

- Fig. 4: eine Detailansicht des Elektrokomponententrägers, wobei der Kontaktanschluß entsprechend einer ersten Ausführungsform montiert ist,
- Fig. 5: eine Detailansicht des Elektrokomponententrägers, wobei der Kontaktanschluß entsprechend einer zweiten Ausführungsform montiert ist,
- Fig. 6: das Trägerelement des Elektrokomponententrägers in räumlicher Darstellung,
- Fig. 7: eine Prinzip-Darstellung der thermischen Verformung von Fixierzapfen auf dem Elektrokomponententräger zur Befestigung der Schaltungsträgerfolie,
- Fig. 8: den Kontaktanschluß wie in Fig. 4 in einer weiteren Ausgestaltung,
- Fig. 9: den Kontaktanschluß wie in Fig. 4 in noch einer weiteren Ausgestaltung und
- Fig. 10: einen elektrischen Schalter mit einem als Kontaktanschluß ausgebildeten elektrischen Anschluß.

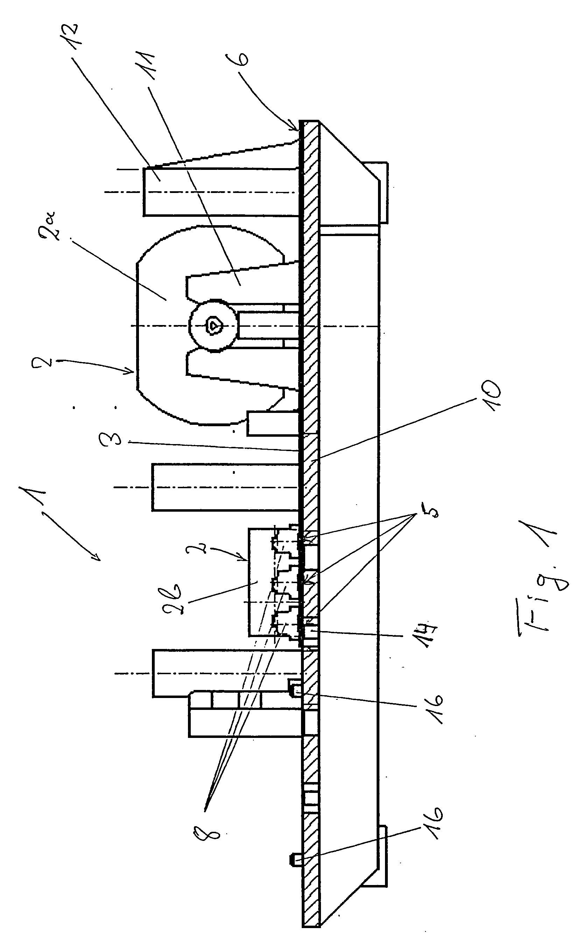

In Fig. 1 ist ein Elektrokomponententräger 1 mit elektrischen, elektronischen o. dgl. Bauteilen 2, und zwar einem Elektromotor 2a sowie einem elektrischen Schalter 2b zu sehen. Selbstverständlich können auf dem Elektrokomponententräger 1 noch weitere Bauteile 2, wie Widerstände, Kondensatoren, Spulen, ICs, Steckanschlüsse o. dgl. angeordnet sein. Solche Elektrokomponententräger 1 werden in Steuergeräten in Kraftfahrzeugen, beispielsweise in Türsteuergeräten von Zentralverriegelungen, eingesetzt.

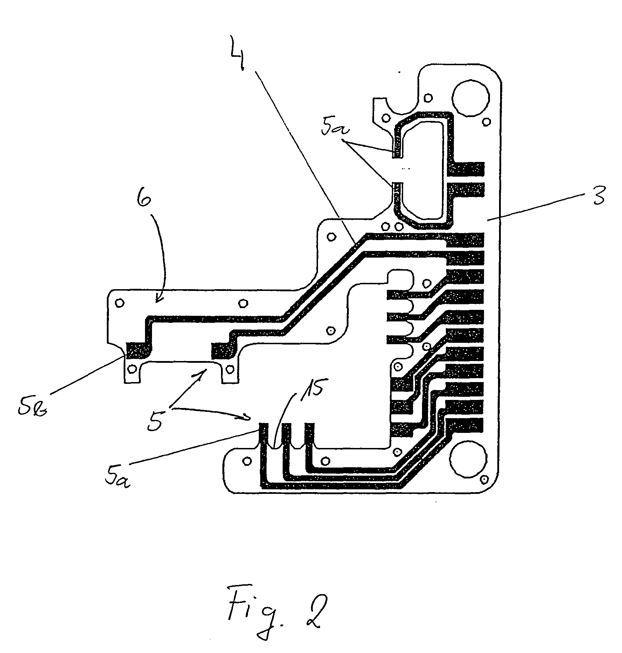

Die Bauteile 2 sind in einer elektrischen Schaltung miteinander verbunden. Für diese elektrische Schaltung besitzt der Elektrokomponententräger 1 einen Schaltungsträger 3. Der Schaltungsträger 3 weist in Fig. 2 sichtbare Leiterbahnen 4 zur elektrischen Verbindung der Bauteile 2 sowie Kontaktflächen 5 zur elektrischen Kontaktierung der Bauteile 2 auf. Die Kontaktflächen 5 sind wiederum mittels Kontaktelementen 8 mit den Bauteilen 2 elektrisch verbunden.

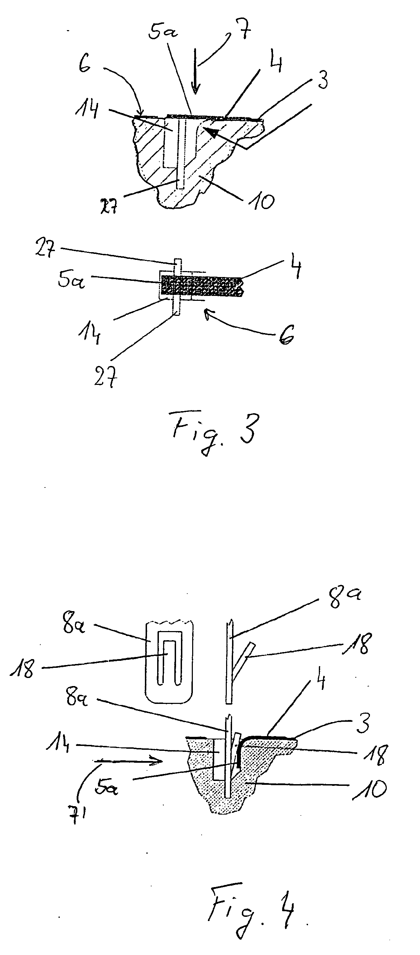

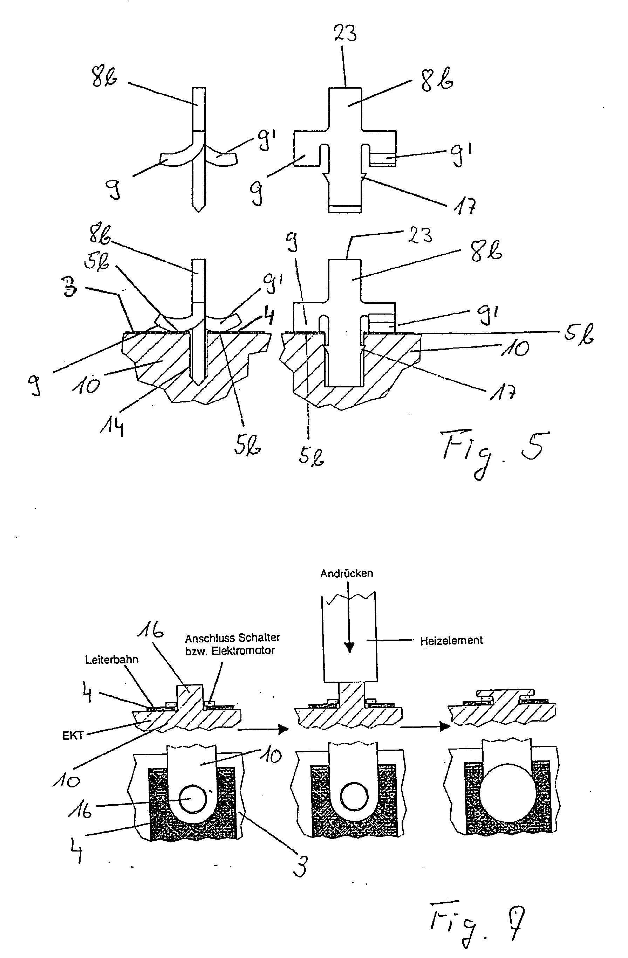

In einer ersten Ausführungsform, die in Fig. 2 zu sehen ist, ist die Kontaktfläche 5a wenigstens teilweise in der Ebene 6 des Schaltungsträgers 3 freigeschnitten und bildet so eine Art von Kontaktzunge oder Kontaktlappen. Dadurch weist die Kontaktfläche 5a eine Flexibilität in eine außerhalb der Ebene 6 des Schaltungsträgers 3 verlaufende Richtung 7 auf. Wie man vor allem anhand der Fig. 3 erkennt, steht diese Richtung 7 in etwa senkrecht zur Ebene 6. Das Kontaktelement 8a zur elektrischen Kontaktierung des Bauteils 2 liegt mit einem Anpreßdruck derart an der Kontaktfläche 5a an, daß die Kontaktfläche 5a aus der Ebene 6 des Schaltungsträgers 3 ausgelenkt ist, wie anhand von Fig. 4 zu erkennen ist. Der Anpreßdruck durch das Kontaktelement 8a wird im wesentlichen in eine parallel zur Ebene 6 des Schaltungsträgers 3 verlaufende Richung 7' ausgeübt.

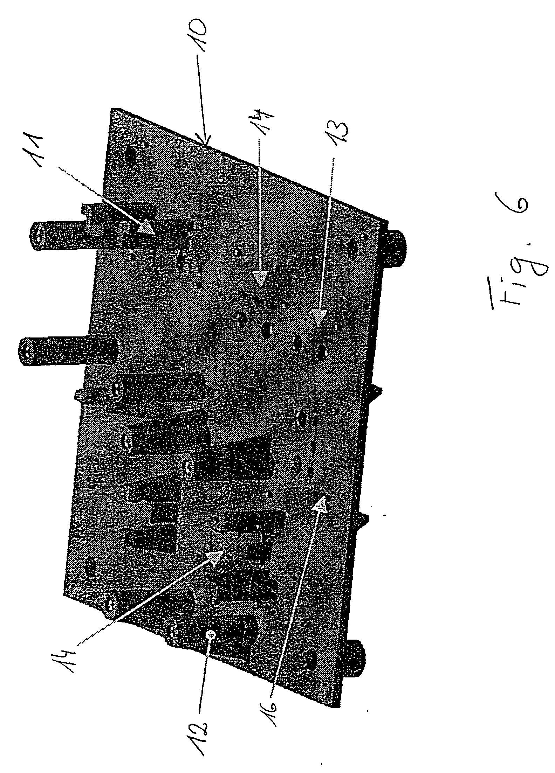

In einer zweiten Ausführungsform, die ebenfalls in Fig. 2 zu sehen ist, ist die Kontaktfläche 5b wenigstens teilweise in der Ebene 6 des Schaltungsträgers 3 freiliegend angeordnet. An der freiliegenden Kontaktfläche 5b liegt das Kontaktelement 8b zur elektrischen Kontaktierung des Bauteils 2 mit einem Anpreßdruck an der Kontaktfläche 5b an, wie anhand von Fig. 5 in Detailansicht gezeigt ist. Hierzu besitzt das Kontaktelement 8b einen in etwa um 90 Grad seitlich abgebogenen Auflagefuß 9. Aus Symmetriegründen ist es zweckmäßig, zwei flügelartig gegenläufig abgebogene Auflagefüße 9, 9' zur Anlage an die Kontaktfläche 5b vorzusehen. Wie anhand von Fig. 5 zu erkennen ist, wird der Anpreßdruck durch das Kontaktelement 8b im wesentlichen in eine senkrecht zur Ebene 6 des Schaltungsträgers 3 verlaufende Richung ausgeübt.

Um die gewünschte Flexibilität der Kontaktflächen 5a zu erzielen, bietet es sich an, als Schaltungsträger 3 eine wenigstens teilweise flexible Leiterplatte zu verwenden. Zweckmäßigerweise handelt es sich dann bei dem Schaltungsträger 3 um eine flexible Schaltungsträgerfolie. Die Schaltungsträgerfolie 3 besteht aus Polyimid, wobei auf der Oberfläche der Schaltungsträgerfolie 3 die Leiterbahnen 4 sowie die Kontaktflächen 5 aus Kupfer in herkömmlicher Additiv- und/oder Subtraktiv-Technik aufgebracht sind. Die Kontaktflächen 5 sind als freigeschnittenes und/oder freiliegendes Ende einer Leiterbahn 4 ausgestaltet, wie anhand der Kontaktflächen 5a, 5b in Fig. 2 zu sehen ist. Um ein Einreißen der Schaltungsträgerfolie 3 beim Auslenken der Kontaktfläche 5a durch das Kontaktelement 8a mit Sicherheit zu verhindern, kann der Zungengrund 15 der freigeschnittenen Kontaktfläche 5a abgerundet sein, wie in Fig. 2 zu erkennen ist.

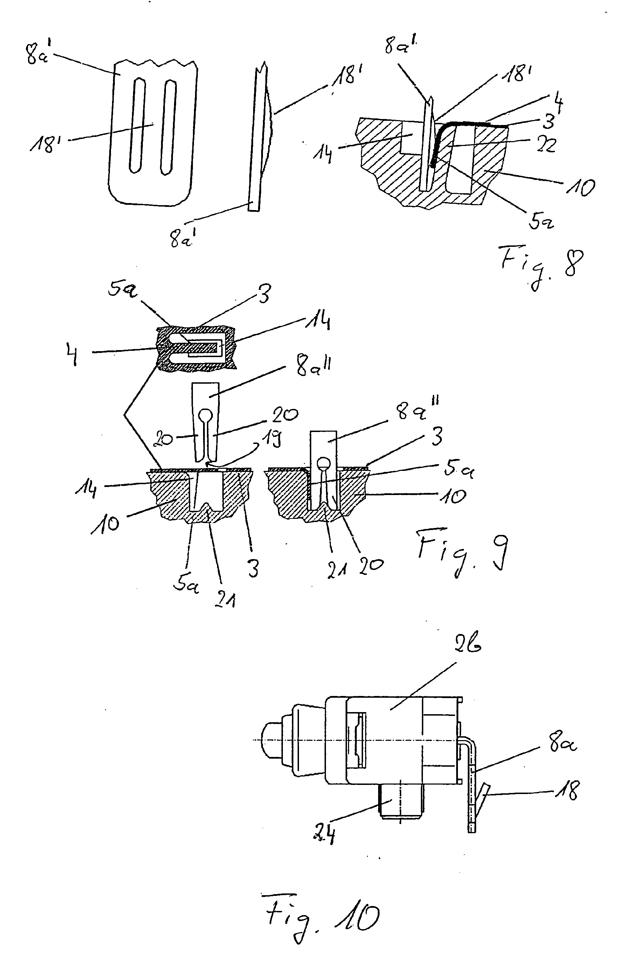

Zwecks Erzielung einer gewissen Stabilität des Elektrokomponententrägers 1 ist die Schaltungsträgerfolie 3 an einem Trägerelement 10 angeordnet. Das in Fig. 6 gezeigte Trägerelement 10 besteht aus Kunststoff, beispielsweise Polyamid, und ist in Spritzgießtechnik hergestellt. Das Trägerelement 10 besitzt Rast-/Schnapp-Haken 11 zur Befestigung der Elektromotoren 2a sowie Befestigungsdome 12 für die Verschraubung von nicht weiter gezeigten Deckplatten, die die Elektromotoren 2a niederhalten. Das Trägerelement 10 besitzt weiter Löcher 13, in die der Schalter 2b mittels entsprechender, in Fig. 10 sichtbarer Rastzapfen 24 an dessen Gehäuse in bekannter Weise fixierend einsteckbar ist.

Die Schaltungsträgerfolie 3 ist auf dem Trägerelement 10 befestigt. Hierzu bietet sich Kleben mit einer eventuellen nachfolgenden Wärmeaushärtung, Nieten, Prägen o. dgl. an. Selbstverständlich kann bei der Herstellung des Trägerelements 10 durch Spritzgießen gleichzeitig die Schaltungsträgerfolie 3 mit hinterspritzt werden. Eine lediglich mechanische Befestigung der Schaltungsträgerfolie 3 auf dem Trägerelement 10 erfolgt mittels einer Schnappverbindung. Besonders bevorzugt ist jedoch aufgrund der einfachen Montage die Befestigung der Schaltungsträgerfolie 3 auf dem Trägerelement 10 mittels Fixierzapfen 16, wie in Fig. 1 zu sehen ist. Die Schaltungsträgerfolie 3 ist mittels in Fig. 2 sichtbarer Fixierlöcher 25 an den Fixierzapfen 16 am Trägerelement 10 aufgesteckt. Zur Sicherung der Befestigung der Schaltungsträgerfolie 3 kann dann anschließend der aus Kunststoff bestehende Fixierzapfen 16 noch mittels eines beheizbaren Stempels 26 thermisch verformt werden, wie anhand von Fig. 7 gezeigt ist.

Schließlich sind im Trägerelement 10 noch Aufnahmen 14 beziehungsweise Ausnehmungen, Ausformungen o. dgl. für die Kontaktelemente 8 angebracht. Bei der ersten Ausführungsform ragt, wie in Fig. 3 zu sehen ist, die Kontaktfläche 5a nach der Befestigung der Schaltungsträgerfolie 3 auf dem Trägerelement 10 in diese Aufnahme14 hinein. Zur elektrischen Verbindung unter Auslenkung der Kontaktflächen 5a ist das Kontaktelement 8a kraft- und/oder formschlüssig derart in Aufnahme 14 eingesteckt, daß das Kontaktelement 8a an der freigeschnittenen Kontaktfläche 5a anliegt, wie in Fig. 4 zu sehen ist. Das Einstecken des Kontaktelements 8a in die Aufnahme 14 wird durch eine entsprechende, in Fig. 3 sichtbare Führung 27 in der Aufnahme 14 erleichtert. Bei der zweiten Ausführungsform gemäß Fig. 5 ist das Kontaktelement 8b ebenfalls in die Aufnahme 14 eingesteckt, wobei die Auflagefüße 9, 9' an der freiliegenden Kontaktfläche 5b anliegen. Zur sicheren Festlegung des Kontaktelements 8 in der Aufnahme 14 kann eine Verzahnung 17, wie sie beispielhaft am Kontaktelement 8b in der Fig. 5 gezeigt ist, verwendet werden, die sich bei der Montage des Kontaktelements 8 in der Aufnahme 14 in diese eingräbt.

Das Kontaktelement 8 kann in der Art eines Steckverbinders ausgestaltet sein. Als Material für das Kontaktelement 8 bietet sich Bronzeblech an, wobei gegebenenfalls dessen Oberfläche verzinnt sein kann. Bei der ersten Ausführungsform weist das Kontaktelement 8a einen wenigstens teilweise freigeschnittenen Abschnitt 18 auf. Wie insbesondere in Fig. 4 zu sehen ist, ist in das Kontaktelement 8a ein in etwa U-förmiger Einschnitt für den Abschnitt 18 eingebracht. Der Abschnitt 18 ist anschließend derart ausgeklinkt, daß dieser in der Art einer federartigen Zunge, eines federnden Schenkels o. dgl. wirkt. Nach dem Einstecken des Kontaktelements 8a in die Aufnahme 14 liegt dann der Abschnitt 18 mit einer Andrückkraft zur Kontaktgabe an der Kontaktfläche 5a an.

In einer weiteren Ausgestaltung gemäß Fig. 8 ist der Abschnitt 18' am Kontaktelement 8a' lediglich mit zwei parallelen Strecken freigeschnitten und anschließend durch plastische Verformung ausgebeult. In der Aufnahme 14 befindet sich ein federnder Steg 22, der die Kontaktfläche 5a an den Abschnitt 18' andrückt. In noch einer weiteren Ausgestaltung gemäß Fig. 9 ist das Kontaktelement 8a" klemmenartig freigeschnitten. Das Kontaktelement 8a" ist mit seiner Klemmenseite 19 derart auf eine keilförmige Erhöhung 21 in der Aufnahme 14 aufgesteckt, daß die Schenkel 20 an der Klemmenseite 19 auseinandergespreizt werden und einer der Schenkel 20 mit einer Anpreßkraft zur Kontaktgabe an der Kontaktfläche 5a anliegt. Die keilförmige Erhöhung 21, der federnde Steg 22 o. dgl. in der Aufnahme 14 dienen damit zur Ausübung und/oder Erhöhung der Anpreßkraft des freigeschnittenen Abschnittes 18, 18' oder des Schenkels 20 an die Kontaktfläche 5a.

Das Kontaktelement 8 kann am Bauteil 2 befestigt oder ein bezüglich des Bauteils 2 separates Teil sein. Der erste Fall ist anhand des Schalters 2b in Fig. 10 verdeutlicht, wo der elektrische Anschluß des Schalters 2b als ein Kontaktelement 8a mit federndem, freigeschnittenem Abschnitt 18 ausgestaltet ist. Der zweite Fall ist anhand des Kontaktelements 8b gemäß Fig. 5 verdeutlicht, wobei dieses Kontaktelement 8b zur elektrischen Kontaktierung des Elektromotors 2a dient. Das Kontaktelement 8b kann an der den Auflagefüßen 9, 9' abgewandten Seite eine Schneidklemm-Kontaktierung 23 aufweisen, an der der Elektromotor 2a kontaktierend aufsteckbar ist.

Zur Herstellung eines erfindungsgemäßen Elektrokomponententrägers 1 bietet sich nachfolgendes Verfahren an. Zunächst wird die Schaltungsträgerfolie 3 auf dem Trägerelement 10 angeordnet, wobei die Kontaktfläche 5 an der Aufnahme 14 im Trägerelement 10 positioniert wird. Anschließend wird das Kontaktelement 8 zur Montage in die Aufnahme 14 eingeführt. Dabei zieht das Kontaktelement 8 die Kontaktfläche 5 in die Aufnahme 14 mit hinein. Befindet sich das Kontaktelement 8 nach der Montage in der Aufnahme 14, so liegt das Kontaktelement 8 mit einem Anpreßdruck an der in der Aufnahme 14 befindlichen Kontaktfläche 5 an. Alternativ kann die Kontaktfläche 5 bei Befestigung der Schaltungsträgerfolie 3 auf dem Trägerelement 10 bereits in die Aufnahme 14 gelegt und gegebenenfalls in dieser befestigt werden. Nach der Montage des Kontaktelements 8 durch Einführen in die Aufnahme 14 liegt dieses dann mit einem Anpreßdruck an der in der Aufnahme 14 befindlichen Kontaktfläche 5 an.

Die Erfindung ist nicht auf die beschriebenen und dargestellten Ausführungsbeispiele beschränkt. Sie umfaßt vielmehr auch alle fachmännischen Weiterbildungen im Rahmen der durch die Patentansprüche definierten Erfindung. So kann ein derartiger Elektrokomponententräger 1 nicht nur in Türsteuergeräten sondern auch in sonstigen Steuergeräten für Kraftfahrzeuge, wie Fensterheber, Spiegelverstellungen o. dgl., eingesetzt werden. Schließlich kann der Elektrokomponententräger 1 nicht nur in Kraftfahrzeugen sondern auch in Elektrogeräten, Haushaltsgeräten, Werkzeugmaschinen o. dgl. Verwendung finden.

### Bezugszeichen-Liste:

- 1:: Elektrokomponententräger
- 2:: elektrisches / elektronisches Bauteil
- 2a:: Elektromotor
- 2b:: elektrischer Schalter
- 3:: Schaltungsträger / Schaltungsträgerfolie
- 4:: Leiterbahn
- 5:: Kontaktfläche
- 5a:: freigeschnittene Kontaktfläche
- 5b:: freiliegende Kontaktfläche
- 6:: Ebene (des Schaltungsträgers)
- 7:: Richtung (für Flexibilität des Schaltungsträgers)
- 7':: Richtung (für Anpreßdruck)
- 8:: Kontaktelement
- 8a:: Kontaktelement (für freigeschnittene Kontaktfläche)
- 8a':: Kontaktelement (weitere Ausgestaltung)
- 8a":: Kontaktelement (noch weitere Ausgestaltung)
- 8b:: Kontaktelement (für freiliegende Kontaktfläche)
- 9,9':: Auflagefuß (von Kontaktelement)
- 10:: Trägerelement (für Elektrokomponententräger)
- 11:: Rast-/Schnapp-Haken (an Trägerelement)
- 12:: Befestigungsdom (an Trägerelement)
- 13:: Loch (in Trägerelement)
- 14:: Aufnahme (in Trägerelement)
- 15:: Zungengrund (von freigeschnittener Kontaktfläche)
- 16:: Fixierzapfen (für Schaltungsträgerfolie)
- 17:: Verzahnung
- 18:: (freigeschnittener) Abschnitt (an Kontaktelement)
- 18':: (freigeschnittener) Abschnitt (gemäß noch weiterer Ausgestaltung)
- 19:: Klemmenseite (an Kontaktelement gemäß weiterer Ausgestaltung)
- 20:: Schenkel (an Kontaktelement gemäß weiterer Ausgestaltung)
- 21:: keilförmige Erhebung (in Aufnahme)
- 22:: federnder Steg (in Aufnahme)
- 23:: Schneidklemm-Kontaktierung (an Kontaktelement)
- 24:: Rastzapfen
- 25:: Fixierloch (in Schaltungsträgerfolie)
- 26:: Stempel
- 27:: Führung (in der Aufnahme)

## Patentansprüche

1. Schaltungsträger für eine elektrische Schaltung, insbesondere in der Art einer wenigstens teilweise flexiblen Leiterplatte, mit elektrischen, elektronischen o. dgl. Bauteilen (2), wie eines Elektromotors (2a), Schalters (2b), Widerstandes, Kondensators, Spule, IC's, Steckanschlusses o. dgl., mit Leiterbahnen (4) zur elektrischen Verbindung der Bauteile (2), sowie mit Kontaktflächen (5) zur elektrischen Kontaktierung der Bauteile (2), **dadurch gekennzeichnet, daß** die Kontaktfläche (5a) wenigstens teilweise in der Ebene (6) des Schaltungsträgers (3) freigeschnitten ist, derart daß die Kontaktfläche (5a) eine Flexibilität in eine außerhalb der Ebene (6) des Schaltungsträgers (3) verlaufende Richtung (7) aufweist, insbesondere in der Art einer Kontaktzunge, und daß ein Kontaktelement (8a, 8a', 8a") zur elektrischen Kontaktierung des Bauteils (2) mit einem Anpreßdruck derart an der Kontaktfläche (5a) anliegt, daß die Kontaktfläche (5a) aus der Ebene (6) des Schaltungsträgers (3) ausgelenkt ist.

2. Schaltungsträger für eine elektrische Schaltung, insbesondere in der Art einer wenigstens teilweise flexiblen Leiterplatte, mit elektrischen, elektronischen o. dgl. Bauteilen (2), wie eines Elektromotors (2a), Schalters (2b), Widerstandes, Kondensators, Spule, IC's, Steckanschlusses o. dgl., mit Leiterbahnen (4) zur elektrischen Verbindung der Bauteile (2), sowie mit Kontaktflächen (5) zur elektrischen Kontaktierung der Bauteile (2), **dadurch gekennzeichnet, daß** die Kontaktfläche (5b) wenigstens teilweise in der Ebene (6) des Schaltungsträgers (3) freiliegend angeordnet ist, daß ein Kontaktelement (8b) zur elektrischen Kontaktierung des Bauteils (2) mit einem Anpreßdruck an der Kontaktfläche (5b) anliegt, und daß das Kontaktelement (8b) einen in etwa um 90 Grad seitlich abgebogenen Auflagefuß (9), insbesondere zwei flügelartig gegenläufig abgebogene Auflagefüße (9, 9'), zur Anlage an die Kontaktfläche (5b) aufweist.

3. Schaltungsträger für eine elektrische Schaltung nach Anspruch 1 oder 2, **dadurch gekennzeichnet, daß** es sich bei dem Schaltungsträger (3) um eine flexible Schaltungsträgerfolie handelt, und daß vorzugsweise die Kontaktfläche (5a, 5b) als freigeschnittenes und/oder freiliegendes Ende einer Leiterbahn (4) ausgestaltet ist.

4. Schaltungsträger für eine elektrische Schaltung nach Anspruch 1, 2 oder 3, **dadurch gekennzeichnet, daß** die Schaltungsträgerfolie (3) an einem, insbesondere aus Kunststoff bestehenden Trägerelement (10) angeordnet ist, wobei vorzugsweise die Schaltungsträgerfolie (3) durch Kleben, Nieten, Prägen, Hinterspritzen, mittels Schnappverbindungen o. dgl. auf dem Trägerelement (10) befestigt ist.

5. Schaltungsträger für eine elektrische Schaltung nach einem der Ansprüche 1 bis 4, **dadurch gekennzeichnet, daß** die Schaltungsträgerfolie (3) auf wenigstens einen Fixierzapfen (16) am Trägerelement (10) aufgesteckt ist, wobei vorzugsweise der Fixierzapfen (16) zur Befestigung der Schaltungsträgerfolie (3) anschließend thermisch verformt ist.

6. Schaltungsträger für eine elektrische Schaltung nach einem der Ansprüche 1 bis 5, **dadurch gekennzeichnet, daß** im Trägerelement (10), eine Aufnahme (14) angebracht ist, daß vorzugsweise die Kontaktfläche (5a) in die Aufnahme (14) hineinragt, und daß weiter vorzugsweise das Kontaktelement (8) kraft- und/oder formschlüssig, gegebenenfalls unter Verwendung einer Verzahnung (17), derart in Aufnahme (14) eingesteckt ist, daß das Kontaktelement (8) an der Kontaktfläche (5) anliegt.

7. Schaltungsträger für eine elektrische Schaltung nach einem der Ansprüche 1 bis 6, **dadurch gekennzeichnet, daß** das Kontaktelement (8) in der Art eines Steckverbinders ausgestaltet ist, daß vorzugsweise das Kontaktelement (8a, 8a', 8a") einen wenigstens teilweise freigeschnittenen, insbesondere in der Aufnahme (14) befindlichen Abschnitt (18, 18'), bei dem es sich beispielsweise um eine federartige Zunge, einen federnden Schenkel (20) o. dgl. handelt, zur Kontaktgabe mit einer Andrückkraft an die Kontaktfläche (5a) aufweist, und daß weiter vorzugsweise in der Aufnahme eine keilförmige Erhöhung (21), ein federnder Steg (22) o. dgl. zur Ausübung und/oder Erhöhung der Anpreßkraft des freigeschnittenen Abschnittes (18, 18') an die Kontaktfläche (5a) angeordnet ist.

8. Schaltungsträger für eine elektrische Schaltung nach einem der Ansprüche 1 bis 6, **dadurch gekennzeichnet, daß** das Kontaktelement (8) am Bauteil (2) befestigt ist oder daß das Kontaktelement (8) als ein bezüglich des Bauteils (2) separates Teil, das beispielsweise eine Schneidklemm-Kontaktierung (23) zum Bauteil (2) aufweist, ausgestaltet ist.

9. Verfahren zur Herstellung eines Schaltungsträgers (3) nach einem der vorangehenden Ansprüche, **dadurch gekennzeichnet, daß** das Kontaktelement (8a, 8a', 8a") in die Aufnahme (14) eingeführt wird, und daß das Kontaktelement (8a, 8 a', 8a") bei der Montage die Kontaktfläche (5a) in die Aufnahme (14) mit hineinzieht, derart daß nach der Montage das Kontaktelement (8a, 8a', 8a") mit einem Anpreßdruck an der in der Aufnahme (14) befindlichen Kontaktfläche (5a) anliegt.

10. Verfahren zur Herstellung eines Schaltungsträgers nach einem der vorangehenden Ansprüche, **dadurch gekennzeichnet, daß** die Kontaktfläche (5a) bei Befestigung der Schaltungsträgerfolie (3) auf dem Trägerelement (10) in die Aufnahme (14) gelegt und gegebenenfalls befestigt wird, und daß das Kontaktelement (8a, 8a', 8a") in die Aufnahme (14) eingeführt wird, derart daß nach der Montage das Kontaktelement (8a, 8a', 8a") mit einem Anpreßdruck an der in der Aufnahme (14) befindlichen Kontaktfläche (5a) anliegt.
